# EUROPÄISCHE PATENTSCHRIFT

(11) **EP 2 804 314 B1**
(45) Veröffentlichungstag und Bekanntmachung des Hinweises auf die Patenterteilung: **13.07.2016**
(21) Anmeldenummer: 13002563.8
(22) Anmeldetag: 16.05.2013
(51) Int. Cl.: H03F 3/193, H03F 1/56

(54) **Schaltungsanordnung und Verfahren zur frequenzabhängigen Anpassung einer Hochfrequenzverstärkerstufe**
Circuit arrangement for and method of frequency-dependent matching of a high frequency amplifier stage
Agencement de circuit et procédé d'adaptation d'un étage d'amplification de hautes-fréquences en fonction de la fréquence

(43) Veröffentlichungstag der Anmeldung: 19.11.2014
(73) Patentinhaber: Airbus Defence and Space GmbH, 85521 Ottobrunn (DE)
(72) Erfinder: Schmid, Ulf, Dr., 89077 Ulm (DE)
(74) Vertreter: Meel, Thomas

(56) Entgegenhaltungen:
- EP-A2- 2 421 151
- WO-A1-99/01931
- DE-A1- 19 823 060
- JP-A- 2006 222 629
- US-A- 5 483 209

## Beschreibung

Die Erfindung betrifft eine Schaltungsanordnung und ein Verfahren zur frequenzabhängigen Anpassung einer Hochfrequenzverstärkerstufe nach den Merkmalen der unabhängigen Patentansprüche.

Leistungsverstärker und deren Transistoren sind üblicherweise inhärent nichtlineare Komponenten, d.h. sie generieren generell Spektralanteile bei ganzzahligen Vielfachen der Frequenz des zu verstärkenden Signals, sogenannte Oberwellen oder Harmonische. Diese Oberwellen oder Harmonische wirken sich in mehrfacher Hinsicht negativ auf das Signalspektrum aus. Zum einen reduzieren sie die Effizienz der Verstärkerschaltung, da ein Teil der aufgewendeten DC-Leistung nicht zur erwünschten Verstärkung der Signalgrundwelle, sondern zur Generierung von Leistung bei den Oberwellenfrequenzen eingesetzt wird. Zum anderen verunreinigen sie das Spektrum des verstärkten Ausgangssignals. Je nach Anwendung muss durch geeignete Filterung die spektrale Reinheit des Signals, z.B. des Radar-Sendesignals, wieder hergestellt werden.

Der Phasen-Verlauf der für eine hohe Effizienz einer reaktiv angepassten Verstärkerschaltung optimalen komplexen Last am Ausgang der Transistoren ist generell über der Frequenz gegenläufig zum physikalisch realisierbaren Phasen-Verlauf passiver Anpassschaltungen. Darum ist eine breitbandige, rein passive und nicht adaptive Realisierung der Anpassschaltung immer ein Kompromiss zwischen Breitbandigkeit, Effizienz und Ausgangsleistung.

Bei schmalbandigen Realisierungen von Verstärkern können zur Optimierung der Effizienz eine oder mehrere Oberwellen gezielt abgeschlossen werden ("harmonic matching"). Auf breitbandige, insbesondere auf mehrere Oktaven abdeckende Schaltungen, ist dieses Verfahren nicht anwendbar, da hier die zu unterdrückenden Oberwellen in das Nutzband der Schaltung fallen und somit nicht bedämpft werden dürfen.
Abstimmbare Filter können verwendet werden, um unerwünschte Spektralanteile wie Oberwellen zu unterdrücken. Da diese jedoch die Oberwellen reflektieren, haben sie eine frequenzabhängige Rückwirkung auf den Leistungsverstärker und beeinflussen somit dessen Eigenschaften mit negativer Auswirkung auf die Effizienz des Verstärkers. Darüber hinaus weisen sie selbst insbesondere bei hohen Frequenzen große Dämpfungen auf, die die Effizienz des Gesamtsystems weiter reduzieren.

Eine Schaltungsanordnung und ein Verfahren zur frequenzabhängigen Beeinflussung von zu übertragenden Signalen gemäß dem Oberbegriff der unabhängigen Ansprüche ist aus DE 24 12 920 A1 bekannt.

Aus EP 2 421 151 A1 ist eine Schaltungsanordnung nach dem Oberbegriff des Patentanspruchs 1 bekannt. Bei dieser Schaltungsanordnung wird ein zu verstärkendes HF-Signal auf einen Teilpfad für ein unteres Frequenzband und ein Teilpfad für ein oberes Frequenzband aufgeteilt, wobei in jedem Teilpfad ein Anpassungsnetzwerk vorhanden ist, in welchem das zu verstärkende HF-Signal bearbeitet. In den Teilpfaden sind Schalter angeordnet, um unerwünschte Spektralanteile auszufiltern.

DE 198 23 060 A1 beschreibt eine Leistungsverstärker-Ausgangsschaltung für eine Mobilfunkeinheit mit Doppelbandbetrieb, enthaltend eine erste Sende/Empfangs-Umschaltschaltung zum Senden/Empfangen eines ersten Sende-/Empfangssignals. Die Schaltung weist Übertragungszweig-Umschaltung auf zum wahlweisen Verbinden der ersten Sende/Empfangs-Umschaltschaltung oder der zweiten Sende/Empfangs-Umschaltschaltung mit einem Leistungsverstärker, der Sendesignale in zwei Frequenzbändern abgibt.

Aufgabe der Erfindung ist es, eine breitbandige Verstärkerschaltung anzugeben, mit der unerwünschte Oberwellen eines verstärkten Signals unterdrückt und die Effizienz der Verstärkerschaltung gesteigert wird. Eine weitere Aufgabe besteht in der Angabe eines Verfahrens mit dem unerwünschte Oberwellen eines verstärkten Signals unterdrückt und gleichzeitig die Effizienz der Verstärkerschaltung gesteigert werden kann.

Diese Aufgaben werden mit einer Schaltungsanordnung gemäß den Merkmalen des geltenden Patentanspruchs 1 sowie einem Verfahren gemäß den Merkmalen des geltenden Patentanspruchs 7 gelöst. Vorteilhafte Ausgestaltungen sind Gegenstand von Unteransprüchen.

Die erfindungsgemäße Schaltungsanordnung zur frequenzabhängigen Anpassung einer Hochfrequenzverstärkerstufe umfasst eine HF-Verstärkerstufe, bei welcher am Ausgang ein das Gesamtfrequenzband führender HF-Gesamtpfad in einen Teilfrequenzpfad (im Weiteren auch als Teilpfade bezeichnet) für ein unteres Frequenzband und einen Teilfrequenzpfad für ein obere Frequenzband aufgespalten ist und nach Bearbeitung der Teilfrequenzbänder in den Teilpfaden diese Teilpfade wieder zum Hochfrequenzgesamtpfad zusammengeführt sind. Erfindungsgemäß weist der Teilfrequenzpfad für das untere Frequenzband ein Anpassnetzwerk zur Anpassung der Hochfrequenzverstärkerstufe in dem vorgegebenen Teilfrequenzband auf, welches eingangsseitig und ausgangsseitig mit einem Tiefpassfilter verbunden ist. Weiterhin weist gemäß der Erfindung der Teilfrequenzpfad für das obere Frequenzband ein Anpassnetzwerk zur Anpassung der Hochfrequenzverstärkerstufe in dem vorgegebenen Teilfrequenzband auf, welches eingangsseitig und ausgangsseitig mit einem Hochpassfilter verbunden ist. Erfindungsgemäß ist der Teilfrequenzpfad für das obere Frequenzband bei Zuführung eines Kontrollsignals schaltbar.

In einer vorteilhaften Ausführungsform der Erfindung ist der Teilfrequenzpfad für das obere Frequenzband gegen Masse abschließbar. Zweckmäßig sind am Anpassnetzwerk des Teilfrequenzpfades für das obere Frequenzband eingangs- und ausgangsseitig wenigstens ein Schalter vorgesehen, welcher ausgebildet ist, bei Zuführung eines Kontrollsignals den Teilfrequenzpfad für das obere Frequenzband gegen Masse kurzzuschließen, so dass Signale in diesem Teilfrequenzpfad reflektiert werden.

In einer weiteren vorteilhaften Ausführungsform der Erfindung ist der Teilfrequenzpfad für das obere Frequenzband bei Zuführung eines Kontrollsignals von der Schaltungsanordnung entkoppelbar. Zweckmäßig erfolgt diese Entkopplung durch den Einsatz von ein oder mehreren Serien-Schaltern, welche in den Teilpfad für das obere Frequenzband geschaltet sind.

Mit anderen Worten, die erfindungsgemäße Schaltungsanordnung beruht auf dem Ansatz, das gesamte Nutzband des HF-Verstärkers in zwei Teilbänder zu unterteilen und das Ausgangssignal des HF-Verstärkers, z. B. eines Transistors auf zwei Teilpfade (Kanäle) zu verteilen, vorzugsweise unter Einsatz von Frequenzweichen (Duplexer oder Triplexer etc.) abhängig vom Teilfrequenzband. In jedem Teilpfad wird der entsprechende Spektralanteil des Ausgangssignals in einer Anpassschaltung bearbeitet. Unerwünschte Spektralanteile können durch Kurzschluss des jeweiligen Teilpfades gegen Masse abgeschlossen oder durch Öffnen von alternativen Serienschaltern im jeweiligen Teilpfad wirksam unterdrückt werden und finden bei Zusammenführung der einzelnen Teilpfade zum HF-Gesamtpfad keine Berücksichtigung im HF-Gesamtsignal mehr.

Die erfindungsgemäße Schaltungsanordnung ermöglicht gegenüber einer Schaltungsanordnung gemäß dem Stand der Technik, bei welcher eine einzelne Anpassschaltung die gesamte Bandbreite nicht-adaptiv abdeckt, eine bessere Näherung an die für maximale Effizienz optimale Last. Darüber hinaus besteht die Möglichkeit, neben der Grundwelle auch die Oberwellen zur Effizienzmaximierung geeignet abzuschließen. Soll z.B. eine normierte Bandbreite ("fractional bandwidth") größer als 2:1 realisiert werden, so ist bei einer Aufteilung des HF-Gesamt-pfades in einen unteren und einen oberen Teilpfad das Anpassnetzwerk für das obere Frequenzband zusätzlich schaltbar ausgeführt, um je nach Frequenzbereich des zu verstärkenden Signals entweder für hohe Frequenzen durchlässig zu sein, oder, falls das zu verstärkende Signal im unteren Teilband liegt, die von der Verstärkerstufe erzeugten Oberwellen geeignet abzuschließen. Durch die Aufteilung des gesamten Nutzbandes in zwei Teilbänder reduziert sich außerdem die Komplexität der einzelnen Anpassnetzwerke in den Teilpfaden gegenüber einem einzelnen Anpassnetzwerk für die gesamte Bandbreite, es werden somit weniger passive Bauteile wie Spulen, Kapazitäten und impedanztransformierende Leitungen benötigt, was geringere Verluste in den Anpassnetzwerken der einzelnen Teilpfade zur Folge hat.

Mit der erfindungsgemäßen Schaltungsanordnung wird abhängig von der Frequenz der zu verstärkenden Grundwelle, der HF-Verstärkerstufe stets die für einen maximalen Wirkungsgrad des Gesamtsystems erforderliche optimale, komplexe Last sowohl für die Grundwelle, als auch für die Oberwellen angeboten. Da bei der Aufteilung des Gesamtbandes in ein Teilband für ein oberes Frequenzband und in ein Teilband für ein unteres Frequenzband durch die vorzugsweise verwendeten Frequenzweichen nicht offensichtlich ist, ob ein Spektralanteil in einem Teilband das erwünschte, verstärkte Signal der zu verstärkenden Grundwelle ist, oder ob dieser Spektralanteil die unerwünschte Oberwelle eines zu verstärkenden Signals in einem unteren Frequenzband ist, ist dem Teilpfad für das obere Frequenzband ein Kontrollsignal zur Unterdrückung von Oberwellen zugeführt, das beispielsweise in einer Signalverarbeitungselektronik generiert wird.

Das erfindungsgemäße Verfahren zeichnet sich im Wesentlichen dadurch aus, dass einem Teilfrequenzpfad für ein oberee Frequenzband ein Kontrollsignal zugeführt wird und dieser Teilfrequenzpfad gegen Masse kurzgeschlossen oder in einer Variante der Erfindung vom Rest der Schaltung entkoppelt wird. Zweckmäßig wird das Kontrollsignal dem Teilfrequenzpfad für das obere Frequenzband zugeführt, welcher eine unerwünschte Oberwelle eines von der Hochfrequenzverstärkerstufe verstärkten Signals führt. Diese unerwünschte Oberwelle wird mittels des erfindungsgemäßen Verfahrens im Gesamtband des von der HF-Verstärkerstufe verstärkten Signals eliminiert.

Die Erfindung sowie weitere vorteilhafte Ausgestaltungen der Erfindung werden im Weiteren anhand von Figuren näher erläutert. Es zeigen:
- Fig.1: ein beispielhaftes Prinzipschaltbild einer erfindungsgemäßen Schaltungsanordnung,
- Fig. 2: eine beispielhafte Schaltung des Teilpfades für das untere Frequenzband aus Fig. 1,
- Fig. 3: eine beispielhafte Schaltung des Teilpfades für das obere Frequenzband aus Fig. 1 mit Schaltern gegen Masse zur Unterdrückung von Oberwellen,
- Fig. 3a: eine beispielhafte Schaltung des Teilpfades für das obere Frequenzband aus Fig. 1 mit Serien-Schaltern zur Unterdrückung von Oberwellen,
- Fig. 4: eine beispielhafte Darstellung der Transmission und Reflexion eines Teilpfades gemäß Fig. 2,
- Fig. 5: eine beispielhafte Darstellung der Transmission und Reflexion eines Teilpfades gemäß Fig. 3, bei offenen Schaltern,
- Fig. 6: eine beispielhafte Darstellung der Transmission und Reflexion eines Teilpfades gemäß Fig. 3, bei geschlossenen Schaltern,
- Fig. 7: den Signalfluss für ein Signal mit unterschiedlichen Spektralanteilen in einer Schaltungsanordnung nach Fig. 1 mit geschlossenen Schaltern in einem Teilpfad nach Fig. 3,
- Fig. 8: den Signalfluss für ein Signal mit unterschiedlichen Spektralanteilen in einer Schaltungsanordnung nach Fig. 1 mit geöffneten Schaltern in einem Teilpfad nach Fig. 3.

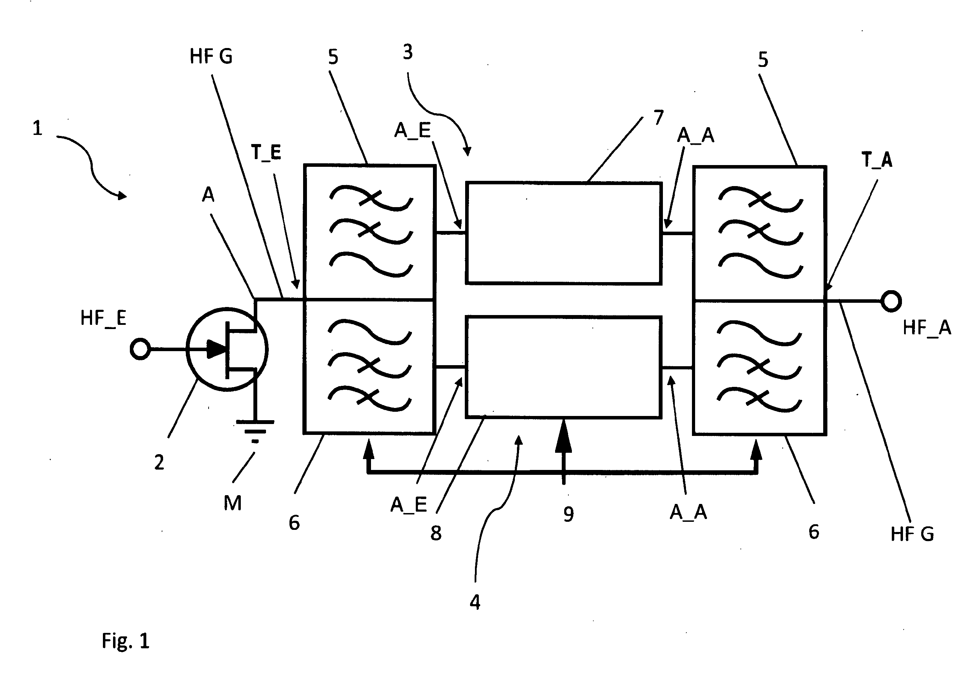

Fig. 1 zeigt das Prinzipschaltbild einer erfindungsgemäßen Schaltungsanordnung. Die Schaltungsanordnung 1 weist einen HF-Eingang HF_E und einem HF-Ausgang HF_A auf. Am HF-Eingang HF_E wird das zu verstärkende HF-Signal der Schaltungsanordnung 1 eingespeist. An den HF-Eingang HF_E ist eine HF-Verstärkerstufe 2, z.B. ein Transistor angeschlossen. Am Ausgang A der HF-Verstärkerstufe 2 ist der HF-Gesamtpfad HF_G in zwei HF-Teilpfade 3, 4 aufgeteilt. Diese Aufteilung erfolgt mittels Frequenzweichen, z.B. Diplexer, welche in Fig. 1 nicht dargestellt sind, aus dem Stand der Technik aber hinreichend bekannt sind. Fig. 1 zeigt beispielhaft die Aufteilung in zwei Teilpfade 3, 4. Es ist aber selbstverständlich möglich, dass der Gesamtpfad HF_G in drei oder mehr Teilpfade aufgeteilt wird. Hierbei werden, einem Fachmann bekannten Frequenzweichen (z.B. Triplexer etc.) eingesetzt.

In dem in Fig. 1 dargestellten Prinzipschaltbild ist der HF-Gesamtpfad HF_G in einen Teilpfad 3 für ein unteres Frequenzband und einen Teilpfad 4 für ein oberes Frequenzband unterteilt. Bei der Aufteilung in mehrere Teilpfade, also mehr als 2 Teilpfade wird das Gesamtfrequenzband des verstärkten HF-Signals in eine entsprechende Anzahl von Frequenzbändern aufgeteilt. Diese Aufteilung erfolgt zweckmäßig am Ausgang A der HF-Verstärkerstufe 2.

Der Teilpfad 3 für das untere Frequenzband besteht im Wesentlichen aus einem Anpassnetzwerk 7 für das untere Frequenzband, welches eingangsseitig A_E und ausgangsseitig A_A mit einem Tiefpassfilter 5 verbunden ist. Der Teilpfad 4 für das obere Frequenzband besteht im Wesentlichen aus einem Anpassnetzwerk 8 für das obere Frequenzband, welches eingangsseitig A_E und ausgangsseitig A_A mit einem Hochpassfilter 6 verbunden ist.

Am HF-Ausgang HF_A der Schaltungsanordnung 1 sind die beiden Teilpfade 3, 4 zusammengeführt, so dass am HF-Ausgang HF_A das Gesamtfrequenzband HF_G des verstärkten Signals anliegt.

Fig. 1 zeigt ferner, dass dem Teilpfad 4 für das obere Frequenzband ein Kontrollsignal 9 zur Unterdrückung von Oberwellen zugeführt ist. Dieses Kontrollsignal 9 wird zweckmäßig in einer Signalverarbeitungseinheit erzeugt, welche hier nicht dargestellt ist.

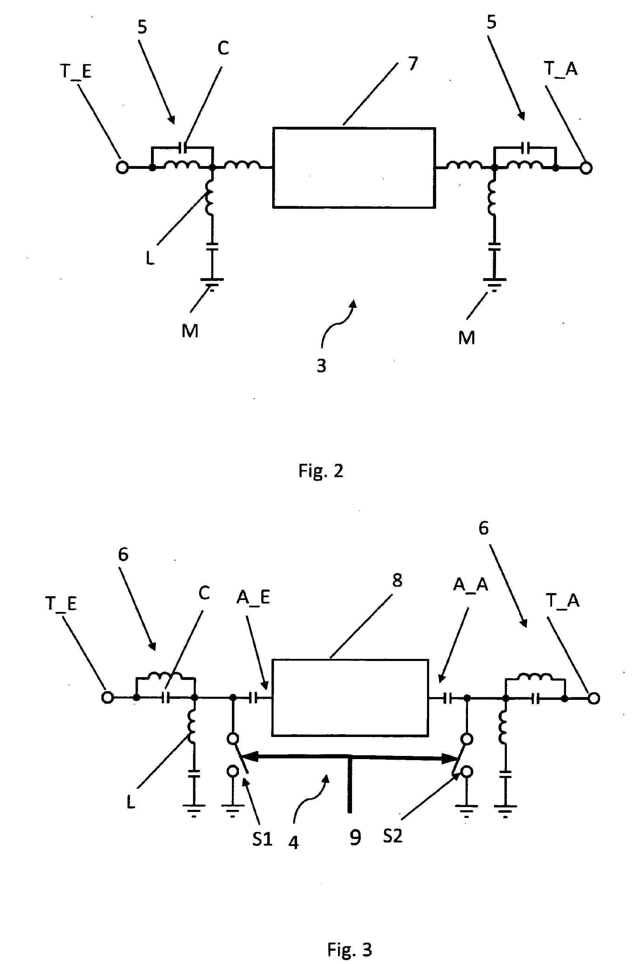

Der Teilpfad 3 für das untere Frequenzband in Fig. 2 besteht, wie bereits in Fig. 1 erläutert, aus drei Teilen, einem eingangsseitigen und einem ausgangsseitigen Tiefpassfilter 5 mit zusätzlichen Bauteilen C, L zur Realisierung von Transmissions-Nullstellen im oberen Frequenzband, sowie einem weniger breitbandigen Anpassnetzwerk 7 zur Anpassung der HF-Verstärkerstufe 2 im unteren Frequenzband. In diesem Zusammenhang bedeutet der Ausdruck "weniger breitbandig", dass dieses Anpassnetzwerk 7 gegenüber einem Anpassnetzwerk aus dem Stand der Technik zur Bearbeitung der gesamten Bandbreite eines von der HF-Verstärkerstufe verstärkten Signals eine geringere Bandbreite aufweist.

Die Tiefpassanteile 5 der in Fig. 2 dargestellten Schaltung, insbesondere die Parallelschwingkreise, bestehend aus Spulen L und Kondensatoren C, erzeugen für Signale im oberen Frequenzband idealerweise einen hochohmigen Abschluss, der den HF-Teilpfad 3 für das obere Frequenzband nicht oder nur vemachlässigbar parasitär belastet. Solche Tiefpassfilter 5 sind einem Fachmann bekannt.

Der Eingang T_E dieses Teilpfades 3 ist mit dem Ausgang A der HF-Verstärkerstufe 2 aus Fig. 1 verbunden. Der Ausgang T_A dieses Teilpfades 3 ist mit dem HF-Ausgang HF_A der Schaltungsanordnung 1 aus Fig. 1 verbunden.

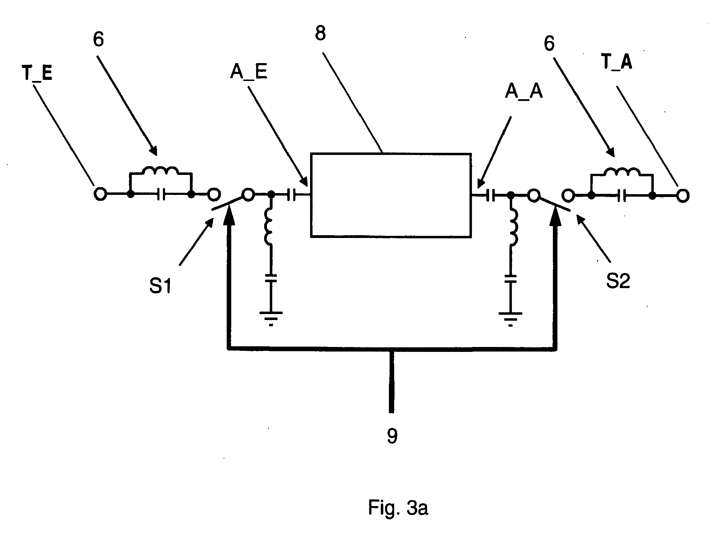

Der Teilpfad 4 für das obere Frequenzband in Fig. 3 besteht ebenfalls aus drei Teilen, einem eingangsseitigen und einem ausgangsseitigen Hochpassfilter 6 mit zusätzlichen Bauteilen C, L zur Realisierung von Transmissions-Nullstellen im unteren Frequenzband, und Schaltern S1, S2, zur Unterdrückung von Oberwellen, wenn diese ins Durchlassband des HF-Teilpfads 4 für hohe Frequenzen fallen, sowie einem weniger breitbandigen Anpassnetzwerk 8 zur Anpassung der HF-Verstärkerstufe 2 im oberen Frequenzband. Die Hochpassanteile 6 der Teilschaltung des Teilpfades 4, insbesondere die Parallelschwingkreise bestehend aus Spulen L und Kondensatoren C, erzeugen für Signale im unteren Frequenzband idealerweise einen hochohmigen Abschluss, der den Hochfrequenzteilpfad 4 für das untere Frequenzband nicht oder nur vernachlässigbar parasitär belastet.

Die Teilschaltung 4 umfasst zwei Schalter S1, S2. Ein Schalter S1 ist zwischen dem Eingang A_E des Anpassnetzwerkes 8 und dem eingangsseitig angeordneten Hochpassfilter 6 gegen Masse M schaltbar angeordnet. Der andere Schalter S2 ist zwischen dem Ausgang A_A des Anpassnetzwerkes 8 und dem ausgangsseitig angeordneten Hochpassfilter 6 gegen Masse M schaltbar angeordnet. Beiden Schaltern S1, S2 ist das Kontrollsignal 9 zur Unterdrückung von Oberwellen zugeführt. Zweckmäßig sind hierfür geeignete Schnittstellen (nicht dargestellt) vorgesehen, welche das Kontrollsignal 9 in ein entsprechendes Schaltsignal wandeln. In Fig. 3 sind die beiden Schalter S1, S2 derart miteinander verschaltet, dass bei Anliegen eines Kontrollsignals 9 beide Schalter S1, S2 gleichzeitig den Eingang T_E des Teilpfades 4 und den Ausgang T_A des HF-Teilpfades 4 mit Masse M verbinden.

Abhängig von der angestrebten Unterdrückung der Oberwellen kann auf einen der beiden Schalter S1 und S2 verzichtet werden. Da die technische Umsetzung von Hochfrequenzschaltem immer auch mit Verlusten verbunden ist, kann bei Verwendung lediglich eines Schalters ein vergleichsweise höherer Wirkungsgrad erreicht werden.

In einer alternativen Ausgestaltung kann der in Fig. 3 dargestellte Teilpfad 4 auch nur einen Schalter S1, S2 aufweisen. Je nach Anordnung des Schalters S1, S2 wird bei Anliegen eines Kontrollsignals 9 der Eingang T_E oder der Ausgang T_A des Teilpfades 4 mit Masse M verbunden. Mit nur einen Schalter S1, S2 ist die erreichbare Unterdrückung geringer als bei der Verwendung von zwei Schaltern

S1, S2, wie in Fig. 3 dargestellt, allerdings ist der Wirkungsgrad vergleichsweise höher.

Fig. 3a zeigt eine beispielhafte Schaltung des Teilpfades für das obere Frequenzband aus Fig. 1 mit zwei Serien-Schaltern S1, S2 zur Unterdrückung von Oberwellen. Hierbei ist der eine Schalter S1 mit dem Eingang T_E des Teilpfades 4 und mit dem Eingang A_E des Anpassnetzwerkes 8 verschaltet. Der andere Schalter S2 schaltet den Ausgang A_A des Anpassnetzwerkes 8 auf den Ausgang T_A des Teilpfades 4. Das Öffnen eines Schalters S1, S2 bewirkt im Wesentlichen eine Entkopplung des Teilpfades 4 von der Schaltungsanordnung 1, wie in Fig. 1 gezeigt.

In einer weiteren Ausführungsform der Erfindung ist es möglich, dass der Teilpfad 4 nur einen Serien-Schalter S1, S2, wie in Fig.3a dargestellt, aufweist. In einer weiteren Ausführungsform der Erfindung können in dem Teilpfad 4 auch Serien-Schalter S1, S2, wie in Fig. 3a dargestellt, und gegen Masse M geschaltete Schalter S1, S2, wie in Fig. 3 dargestellt, miteinander kombiniert sein.

In einer weiteren Ausführungsform der Erfindung sind die Bauteile, insbesondere Spulen L und Kondensatoren C, der Tiefpassfilter 5 der Teilschaltung in Fig. 2 sowie die Bauteile, insbesondere Spulen L und Kondensatoren C, der Hochpassfilter 6 der Teilschaltung in Fig. 3 bzw. Fig. 3a derart dimensioniert, dass die Tiefpassfilter 5 und/oder Hochpassfilter 6 die impedanztransformierende Wirkung und Funktionalität der Anpassnetzwerke 7, 8 erfüllen. Zweckmäßig können die Anpassnetzwerke 7, 8 mit entsprechend dimensionierten Tiefpassfiltern 5 und/oder Hochpassfiltern 6 entfallen. Eine entsprechende Dimensionierung ist einem Fachmann bekannt.

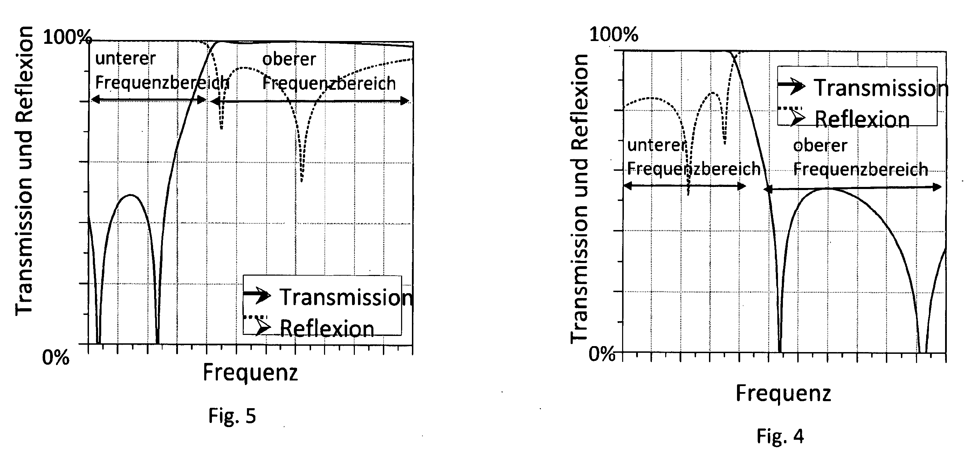

Fig. 4 bis 6 zeigen im Wesentlichen geschätzte HF-Eigenschaften, insbesondere Transmission und Reflexion der einzelnen Teilschaltungen in Fig. 2 und 3 für das untere bzw. das obere Frequenzband. Die Achsen der in Fig. 4 bis 6 dargestellten Diagramme sind dimensionslos dargestellt. Auf der x-Achse ist jeweils die Frequenz dargestellt und zwar mit von links nach rechts ansteigender Frequenz. Auf der y-Achse sind jeweils Transmission und Reflexion in logarithmischer Darstellung dargestellt von unten 0% bis oben 100%.

In Fig. 4 wird ein im unteren Teilband verstärktes Nutzsignal über die Teilschaltung 3 in Fig. 2 unter geeigneten Anpassbedingungen zur Last geführt. Oberwellen und Nutzwellen im oberen Teilband, d.h. bei hohen Frequenzen werden am Eingang der Teilschaltung reflektiert. In der Darstellung sind die beispielhafte Reflexion mit der gepunkteten Linie und die Transmission mit der durchgezogenen Linie dargestellt. Aus Fig. 4 wird deutlich, dass die Reflexion im unteren Frequenzbereich sehr kleine Werte annimmt. Im oberen Frequenzbereich beträgt die Reflexion nahe 100%. Komplementäres gilt für die Transmission. Im unteren Frequenzbereich liegt die Transmission bei nahezu 100%, im oberen Frequenzbereich fällt die Transmission auf sehr kleine Werte ab.

Fig. 5 zeigt die geschätzten HF-Eigenschaften der Teilschaltung 4 für das obere Frequenzband in Fig. 3, wenn die Schalter S1, S2 geöffnet sind. Ein im oberen Teilband verstärktes Nutzsignal wird unter geeigneten Anpassbedingungen zur Last geführt. In der Darstellung sind die beispielhafte Reflexion mit der gepunkteten Linie und die Transmission mit der durchgezogenen Linie dargestellt. Aus Fig. 5 wird deutlich, dass die Reflexion im oberen Frequenzbereich kleine Werte annimmt. Im unteren Frequenzbereich beträgt die Reflexion nahe 100%. Komplementäres gilt für die Transmission. Im oberen Frequenzbereich liegt die Transmission bei nahezu 100%, im unteren Frequenzbereich fällt die Transmission auf sehr kleine Werte ab.

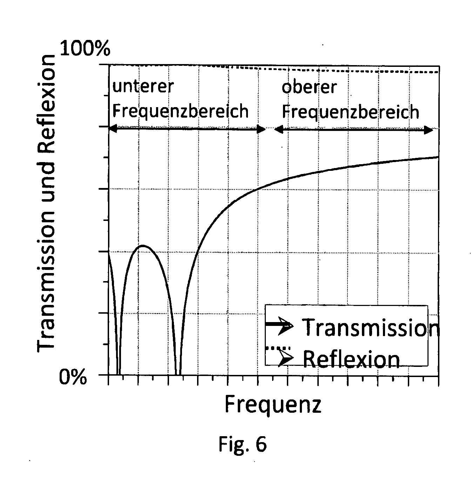

Fig. 6 zeigt die geschätzten HF-Eigenschaften der Teilschaltung 4 für das obere Frequenzband in Fig. 3, wenn das zu verstärkende Signal am Eingang der Verstärkerschaltung im unteren Frequenzband liegt und der oder die Schalter geschlossen sind. In diesem Fall müssen die am Transistor erzeugten Oberwellen, die in das Durchlassband des Hochpassfilters fallen, geeignet reflektiert werden. In der Darstellung sind die beispielhafte Reflexion mit der gepunkteten Linie und die Transmission mit der durchgezogenen Linie dargestellt. Aus Fig. 6 wird deutlich, dass die Transmission im unteren Frequenzbereich auch bis zu sehr kleinen Werten abfällt und auch im oberen Frequenzbereich nur langsam ansteigt. Die Reflexion liegt allerdings im gesamten Frequenzbereich nahe 100%. Dies bedeutet, dass das anliegende Signal im gesamten Frequenzband des Teilpfades 4 für das obere Frequenzband nahezu vollständig reflektiert wird und nicht an den HF-Ausgang HF_A durchgelassen wird.

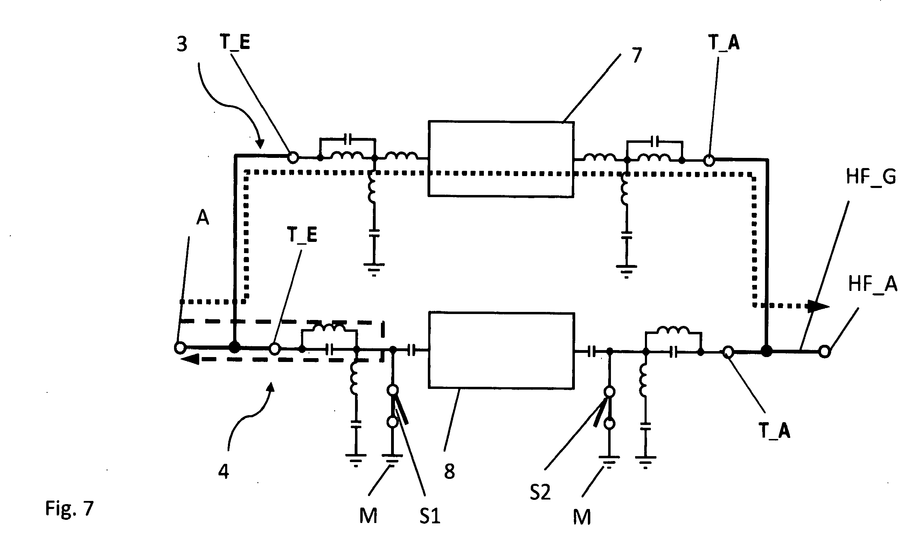

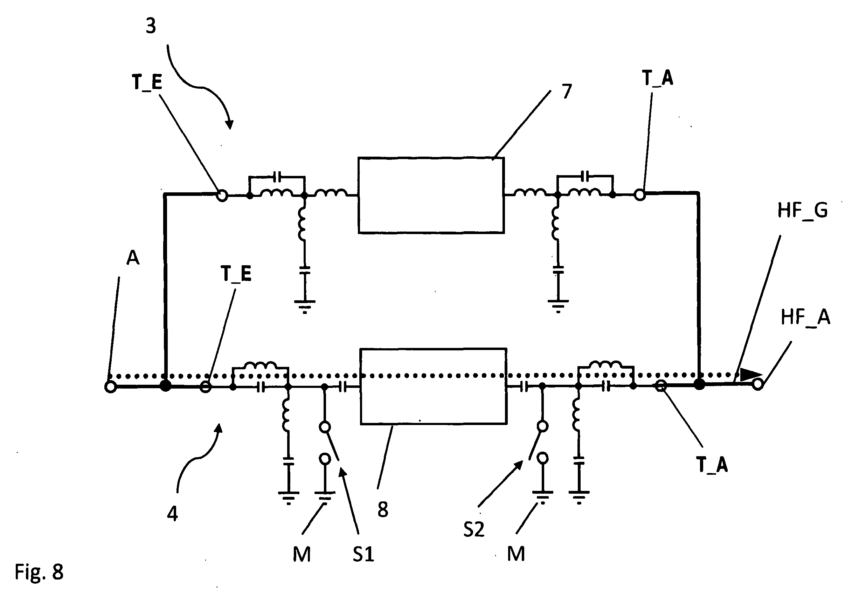

Der Signalfluss für Signale mit unterschiedlichen Spektralanteilen ist anhand von Pfeilen schematisch in Fig. 7 und in Fig. 8 dargestellt. Sollen Signale im unteren Frequenzbereich verstärkt werden, so wird das Signal (angedeutet durch den gepunkteten Pfeil in Fig. 7) grundsätzlich über den Teilpfad 3 für das untere Frequenzband (obere Teilschaltung in Fig. 7) geführt. In diesem Fall werden über ein externes Kontrollsignal 9 die beiden Schalter S1, S2 im Teilpfad 4 für das obere Frequenzband (untere Teilschaltung in Fig. 7) geschlossen. Die in der HF-Verstärkerstufe 2, also z.B. dem in Fig. 1 gezeigten Transistor erzeugten Oberwellen werden, falls sie in das Durchlassband des Hochpassfilters 6 fallen, auf diese Weise geeignet reflektiert (angedeutet durch den gestrichenen Pfeil in Fig. 7).

Sollen Signale im oberen Frequenzband verstärkt werden, so werden die durch die in der HF-Verstärkerstufe 2 verstärkten Signale (angedeutet durch den gepunkteten Pfeil in Fig. 8) grundsätzlich über den Teilpfad 4 für das obere Frequenzband (untere Teilschaltung in Fig. 8) geführt. Dazu werden über das externe Kontrollsignal 9 die beiden Schalter S1, S2 im Teilpfad 4 für das obere Frequenzband (untere Teilschaltung in Fig. 8) geöffnet.

Auch zeigt sich ein Vorteil der Erfindung, dass für den reduzierten Frequenzbereich ein für maximalen Wirkungsgrad optimiertes Anpassnetzwerk in besserer Näherung implementiert werden kann, als wenn das gesamte Durchlassband des HF-Verstärkers mit einem Anpassnetzwerk realisiert werden würde.

### Bezugszeichen

- 1: Schaltungsanordnung
- 2: HF-Verstärkerstufe
- 3: Teilpfad für unteres Frequenzband
- 4: Teilpfad für oberes Frequenzband
- 5: Tiefpassfilter
- 6: Hochpassfilter
- 7: Anpassnetzwerk für unteres Frequenzband
- 8: Anpassnetzwerk für oberes Frequenzband
- 9: Kontrollsignal
- C: Kondensator
- L: Spule
- M: Masse
- S1: Schalter
- S2: Schalter
- A: Ausgang HF-Verstärkerstufe
- HF_G: HF-Gesamtpfad
- HF_A: Ausgang Schaltungsanordnung
- HF_E: Eingang Schaltungsanordnung
- T_E: Eingang Teilpfade
- T_A: Ausgang Teilpfad
- A_E: Eingang Anpassnetzwerk
- A_A: Ausgang Anpassnetzwerk

## Patentansprüche

1. Schaltungsanordnung zur frequenzabhängigen Anpassung einer Hochfrequenzverstärkerstufe (2), bei welcher am Ausgang (A) der Hochfrequenzverstärkerstufe (2) ein das Gesamtfrequenzband führender Hochfrequenzgesamtpfad (HF_G) in einen Teilfrequenzpfad (3) für ein unteres Frequenzband und einen Teilfrequenzpfad (4) für ein oberes Frequenzband für jeweils vorgegebene Teilfrequenzbänder aufgespalten ist und nach Bearbeitung der Teilfrequenzbänder diese Teilfrequenzpfade (3, 4) wieder zum Hochfrequenzgesamtpfad (HF_G) zusammengeführt sind, **dadurch gekennzeichnet, dass**
der Teilfrequenzpfad (3) für das untere Frequenzband ein Anpassnetzwerk (7) zur Anpassung der Hochfrequenzverstärkerstufe (2) in dem vorgegebenen Teilfrequenzband aufweist, welches eingangsseitig und ausgangsseitig jeweils mit einem Tiefpassfilter (5) verbunden ist und dass der Teilfrequenzpfad (4) für das obere Frequenzband ein Anpassnetzwerk (8) zur Anpassung der Hochfrequenzverstärkerstufe (2) in dem vorgegebenen Teilfrequenzband aufweist, welches eingangsseitig und ausgangsseitig jeweils mit einem Hochpassfilter (5) verbunden ist und dass wenigstens ein Teilfrequenzpfad (3, 4) bei Zuführung eines Kontrollsignals (9) schaltbar ist.

2. Schaltungsanordnung nach Anspruch 1, **dadurch gekennzeichnet, dass** am Anpassnetzwerk (8) des Teilfrequenzpfades (4) für das obere Frequenzband eingangs- und/oder ausgangsseitig wenigstens ein Schalter (S) vorgesehen ist, welcher ausgebildet ist, bei Zuführung eines Kontrollsignals (9) den Teilfrequenzpfad (4) für das obere Frequenzband gegen Masse (M) kurzzuschließen, so dass Signale in dem Teilfrequenzpfad (4) für das obere Frequenzband reflektiert werden.

3. Schaltungsanordnung nach Anspruch 1 oder 2, **dadurch gekennzeichnet, dass** am Anpassnetzwerk (8) des Teilfrequenzpfades (4) für das obere Frequenzband eingangs- und/oder ausgangsseitig wenigstens ein Serien-Schalter (S1, S2) vorgesehen ist, welcher ausgebildet ist, bei Zuführung eines Kontrollsignals (9) den Teilfrequenzpfad (4) für das obere Frequenzband von der Schaltungsanordnung (1) zu entkoppeln.

4. Schaltungsanordnung nach einem der vorangehenden Ansprüche, **dadurch gekennzeichnet, dass** Frequenzweichen vorgesehen sind zur Aufteilung eines Ausgangssignals der Hochfrequenzverstärkerstufe (2) auf den Teilfrequenzpfad (3) für das untere Frequenzband un den Teilfrequenzpfad (4) für das obere Frequenzband.

5. Schaltungsanordnung nach einem der Ansprüche 1 bis 5, **dadurch gekennzeichnet, dass** die Schalter (S1, S2) in Form von Schalttransistoren ausgeführt sind und die gesamte Schaltungsanordnung (1) zusammen mit einer oder mehreren Verstärkerstufen (2) auf demselben Halbleiter-Chip monolithisch integriert ist.

6. Schaltungsanordnung nach einem der Ansprüche 1 bis 5, **dadurch gekennzeichnet, dass** die Schalter (S1, S2) in Form von Micro-Electro-Mechanical Systems (MEMS) ausgeführt sind.

7. Verfahren zur frequenzabhängigen Anpassung einer Hochfrequenzverstärkerstufe, wobei das Gesamtfrequenzband eines zu verstärkenden HF-Signals in einen Teilfrequenzpfad (3) für ein unteres Frequenzband und einen Teilfrequenzpfad (4) für ein oberes Frequenzband aufgeteilt wird und nach Bearbeitung der Teilfrequenzbänder in den Teilfrequenzpfaden (3, 4) das Gesamtfrequenzband (HF_G) des verstärkten Signals zusammengeführt wird, wobei dem Teilfrequenzpfad (4) für das obere Frequenzband ein Kontrollsignal (9) zugeführt wird und dieser Teilfrequenzpfad (4) geschaltet wird, **dadurch gekennzeichnet, dass** das HF-Signal im Teilfrequenzpfad (3) für das untere Frequenzband in einem Anpassnetzwerk (7) mit einem eingangs - und ausgangsseitigen Tiefpassfilter (5) und im Teilfrequenzpfad (4) für das obere Frequenzband in einem Anpassnezwerk (8) mit einem eingangs- und ausgangsseitigen Hochpassfilter (6) bearbeitet wird.

8. Verfahren nach Anspruch 7, **dadurch gekennzeichnet, dass** für ein im unteren Teilfrequenzband befindliches HF-Nutzsignal bei geschlossenem Schalter durch geeignete Ausführung des Anpassnetzwerks (8) und der frequenzbestimmenden Bauelemente im Pfad für das untere Teilfrequenzband (4) eine oder mehrere der in der HF-Verstärkerstufe (2) erzeugten Oberwellen für einen maximalen Wirkungsgrad der Gesamtschaltung geeignet reflektiert werden

9. Verfahren nach Anspruch 7 oder 8, **dadurch gekennzeichnet, dass** das Kontrollsignal (9) wenigstens einem Schalter (S) zugeführt wird, welcher mit dem Eingang und Ausgang des Anpassnetzwerkes (8) des Teilfrequenzpfades (4) für das obere Frequenzband verbunden ist.

10. Verfahren nach einem der Ansprüche 7 bis 9, **dadurch gekennzeichnet, dass** das Kontrollsignal (9) in einer Signalverarbeitungselektronik generiert wird und dem Teilfrequenzpfad (4) für das obere Frequenzband zugeführt wird, welcher eine unerwünschte Oberwelle eines von der Hochfrequenzverstärkerstufe (2) verstärkten Signals führt.

11. Verfahren nach einem der Ansprüche 7 bis 10, **dadurch gekennzeichnet, dass** der Teilfrequenzpfad (4) für das obere Frequenzband gegen Masse (M) geschaltet wird.

12. Verfahren nach einem der Ansprüche 7 bis 11, **dadurch gekennzeichnet, dass** der Teilfrequenzpfad (4) für das obere Frequenzband entkoppelt wird.

## Claims

1. Circuit arrangement for frequency-dependent adjustment of a high-frequency amplifier stage (2), in which, at the output (A) of the high-frequency amplifier stage (2), a total high-frequency path (HF_G) carrying the total frequency band is split into a frequency subpath (3) for a lower frequency band and a frequency subpath (4) for an upper frequency band for respectively prescribed frequency subbands and, after the frequency subbands have been processed, these frequency subpaths (3, 4) are recombined to form the total high-frequency path (HF_G), **characterized in that**
the frequency subpath (3) for the lower frequency band has a matching network (7) for adjusting the high-frequency amplifier stage (2) in the prescribed frequency subband, which matching network has its input side and its output side respectively connected to a low-pass filter (5), and **in that** the frequency subpath (4) for the upper frequency band has a matching network (8) for adjusting the high-frequency amplifier stage (2) in the prescribed frequency subband, which matching network has its input side and its output side respectively connected to a high-pass filter (5), and **in that** at least one frequency subpath (3, 4) is switchable when a control signal (9) is supplied.

2. Circuit arrangement according to Claim 1, **characterized in that** the input and/or output side(s) of the matching network (8) of the frequency subpath (4) for the upper frequency band is/are provided with at least one switch (S) that is designed to short the frequency subpath (4) for the upper frequency band to earth (M) when a control signal (9) is supplied, so that signals in the frequency subpath (4) for the upper frequency band are reflected.

3. Circuit arrangement according to Claim 1 or 2, **characterized in that** the input and/or output side(s) of the matching network (8) of the frequency subpath (4) for the upper frequency band is/are provided with at least one series switch (S1, S2) that is designed to decouple the frequency subpath (4) for the upper frequency band from the circuit arrangement (1) when a control signal (9) is supplied.

4. Circuit arrangement according to one of the preceding claims, **characterized in that** frequency filters are provided for splitting an output signal from the high-frequency amplifier stage (2) onto the frequency subpath (3) for the lower frequency band and the frequency subpath (4) for the upper frequency band.

5. Circuit arrangement according to one of Claims 1 to 5, **characterized in that** the switches (S1, S2) are embodied in the form of switching transistors and the whole circuit arrangement (1) together with one or more amplifier stages (2) is monolithically integrated on the same semiconductor chip.

6. Circuit arrangement according to one of Claims 1 to 5, **characterized in that** the switches (S1, S2) are embodied in the form of microelectromechanical systems (MEMS).

7. Method for frequency-dependent adjustment of a high-frequency amplifier stage, wherein the total frequency band of an HF signal to be amplified is split into a frequency subpath (3) for a lower frequency band and a frequency subpath (4) for an upper frequency band and, after the frequency subbands have been processed in the frequency subpaths (3, 4), the total frequency band (HF_G) of the amplified signal is combined, wherein the frequency subpath (4) for the upper frequency band is supplied with a control signal (9) and this frequency subpath (4) is switched, **characterized in that** the HF signal is processed in the frequency subpath (3) for the lower frequency band in a matching network (7) having an input-side and an output-side low-pass filter (5) and in the frequency subpath (4) for the upper frequency band in a matching network (8) having an input-side and an output-side high-pass filter (6).

8. Method according to Claim 7, **characterized in that** for an HF useful signal in the lower frequency subband, with the switch closed, suitable embodiment of the matching network (8) and of the frequency-determining components in the path for the lower frequency subband (4) prompts one or more of the harmonics produced in the HF amplifier stage (2) to be reflected in a suitable manner for maximum efficiency of the overall circuit.

9. Method according to Claim 7 or 8, **characterized in that** the control signal (9) is supplied to at least one switch (S) that is connected to the input and the output of the matching network (8) of the frequency subpath (4) for the upper frequency band.

10. Method according to one of Claims 7 to 9, **characterized in that** the control signal (9) is generated in signal processing electronics and is supplied to the frequency subpath (4) for the upper frequency band, which subpath carries an undesirable harmonic of a signal amplified by the high-frequency amplifier stage (2).

11. Method according to one of Claims 7 to 10, **characterized in that** the frequency subpath (4) for the upper frequency band is connected to earth (M).

12. Method according to one of Claims 7 to 11, **characterized in that** the frequency subpath (4) for the upper frequency band is decoupled.

## Revendications

1. Agencement de circuit pour l'adaptation d'un étage amplificateur à haute fréquence (2) en fonction de la fréquence, dans lequel un trajet global à haute fréquence (HF_G) acheminant une bande de fréquences globale est subdivisé à la sortie (A) de l'étage amplificateur à haute fréquence (2) en un trajet de fréquence partiel (3) destiné à une bande de fréquences inférieure et en un trajet de fréquence partiel (4) destiné à une bande de fréquences supérieure pour des bandes de fréquences partielles prédéterminées respectives et, après un traitement des bandes de fréquences partielles, lesdits trajets de fréquence partiels (3, 4) sont recombinés en le trajet global à haute fréquence (HF_G), **caractérisé en ce que** le trajet de fréquence partiel (3) destiné à la bande de fréquences inférieure comporte un réseau d'adaptation (7) destiné à adapter l'étage amplificateur à haute fréquence (2) dans la bande de fréquences partielle prédéterminée, lequel réseau d'adaptation est respectivement connecté en entrée et en sortie à un filtre passe-bas (5) et **en ce que** le trajet de fréquence partiel (4) destiné à la bande de fréquences supérieure comporte un réseau d'adaptation (8) destiné à adapter l'étage amplificateur à haute fréquence (2) dans la bande de fréquences partielle prédéterminée, lequel réseau d'adaptation est respectivement connecté en entrée et en sortie à un filtre passe-haut (5) et **en ce qu'**au moins un trajet de fréquence partiel (3, 4) peut être commuté lors de l'application d'un signal de commande (9).

2. Agencement de circuit selon la revendication 1, **caractérisé en ce qu'**il est prévu au moins un commutateur (S) en entrée et/ou en sortie sur le réseau d'adaptation (8) du trajet de fréquence partiel (4) destiné à la bande de fréquences supérieure, lequel commutateur est conçu pour court-circuiter à la masse (M) le trajet de fréquence partiel (4) destiné à la bande de fréquence supérieure lors de l'application d'un signal de commande (9) de manière à réfléchir les signaux passant sur le trajet de fréquence partiel (4) destiné à la bande de fréquences supérieure.

3. Agencement de circuit selon la revendication 1 ou 2, **caractérisé en ce qu'**il est prévu en entrée et/ou en sortie au moins un commutateur série (S1, S2) sur le réseau d'adaptation (8) du trajet de fréquence partiel (4) destiné à la bande de fréquences supérieure, lequel commutateur série est conçu pour découpler le trajet de fréquence partiel (4) destiné à la bande de fréquence supérieure de l'agencement de circuit (1) lors de l'application d'un signal de commande (9).

4. Agencement de circuit selon l'une quelconque des revendications précédentes, **caractérisé en ce qu'**il est prévu des diviseurs de fréquence pour diviser un signal de sortie de l'étage amplificateur à haute fréquence (2) en le trajet de fréquence partiel (3) destiné à la bande de fréquences inférieure et en le trajet de fréquence partiel (4) destiné à la bande de fréquences supérieure.

5. Agencement de circuit selon l'une quelconque des revendications 1 à 5, **caractérisé en ce que** les commutateurs (S1, S2) sont réalisés sous la forme de transistors de commutation et **en ce que** l'ensemble de l'agencement de circuit (1) est intégré de manière monolithique en association avec un ou plusieurs étages amplificateurs (2) sur la même puce à semi-conducteur.

6. Agencement de circuit selon l'une quelconque des revendications 1 à 5, **caractérisé en ce que** les commutateurs (S1, S2) sont réalisés sous la forme de systèmes micro-électro-mécaniques (MEMS).

7. Procédé d'adaptation d'un étage amplificateur à haute fréquence en fonction de la fréquence, dans lequel la bande de fréquences globale d'un signal HF à amplifier est divisée en un trajet de fréquence partiel (3) destiné à une bande de fréquences inférieure et en un trajet de fréquence partiel (4) destiné à une bande de fréquences supérieure et en ce qu'après traitement des bandes de fréquences partielles sur les trajets de fréquence partiels (3, 4), la bande de fréquences globale (HF_G) du signal amplifié est recombinée, dans lequel un signal de commande (9) est appliqué au trajet de fréquence partiel (4) destiné à la bande de fréquences supérieure et ledit trajet de fréquence partiel (4) est commuté, **caractérisé en ce que** le signal HF est traité sur le trajet de fréquence partiel (3) destiné à la bande de fréquences inférieure dans un réseau d'adaptation (7) au moyen d'un filtre passe-bas (5) situé en entrée et en sortie, et sur le trajet de fréquence partiel (4) destiné à la bande de fréquences supérieure dans un réseau d'adaptation (8) comportant un filtre passe-haut (6) situé en entrée et en sortie.

8. Procédé selon la revendication 7, **caractérisé en ce que**, pour un signal utile HF se trouvant dans la bande de fréquences inférieure, lorsque le commutateur est fermé au moyen d'une configuration appropriée du réseau d'adaptation (8) et des composants déterminant les fréquences sur le trajet destiné à la bande de fréquences partielle inférieure (4), un ou plusieurs des harmoniques générés dans l'étage amplificateur HF (2) sont réfléchis de manière appropriée pour un rendement maximal de l'ensemble de circuit.

9. Procédé selon la revendication 7 ou 8, **caractérisé en ce que** le signal de commande (9) est acheminé à au moins un commutateur (S) qui est connecté à l'entrée et à la sortie du réseau d'adaptation (8) du trajet de fréquence partiel (4) destiné à la bande de fréquences supérieure.

10. Procédé selon l'une quelconque des revendications 7 à 9, **caractérisé en ce que** le signal de commande (9) est généré dans une électronique de traitement des signaux et **en ce qu'**il est appliqué au trajet de fréquence partiel (4) destiné à la bande de fréquences supérieure, qui achemine un harmonique indésirable d'un signal amplifié par l'étage amplificateur à haute fréquence (2).

11. Procédé selon l'une quelconque des revendications 7 à 10, **caractérisé en ce que** le trajet de fréquence partiel (4) destiné à la bande de fréquences supérieure est connecté à la masse (M).

12. Procédé selon l'une quelconque des revendications 7 à 11, **caractérisé en ce que** le trajet de fréquence partiel (4) destiné à la bande de fréquences supérieure est découplé.
